# EUROPÄISCHE PATENTSCHRIFT

(11) **EP 0 641 057 B1**
(45) Veröffentlichungstag und Bekanntmachung des Hinweises auf die Patenterteilung: **18.03.1998**
(21) Anmeldenummer: 94113042.9
(22) Anmeldetag: 21.08.1994
(51) Int. Cl.: H02J 3/00, H02J 13/00, G01R 19/165, H05K 7/10

(54) **Verteilerssysteem für zwei oder mehrere elektrische Verbraucher**
Distribution system for two or more electrical consumers
Système de distribution pour deux ou plusieurs consommateurs électriques

(30) Priorität: 25.08.1993 AT 1709/93
(43) Veröffentlichungstag der Anmeldung: 01.03.1995
(73) Patentinhaber: Harbauer, Heinrich, 6150 Steinach (AT)
(72) Erfinder: Harbauer, Heinrich, 6150 Steinach (AT)
(74) Vertreter: Torggler, Paul, Dr.

(56) Entgegenhaltungen:
- EP-A- 0 224 407
- DE-A- 3 121 409
- DE-A- 3 709 227
- US-A- 4 652 769
- US-A- 4 731 703
- US-A- 4 769 557

## Beschreibung

Die Erfindung betrifft ein Verteilersystem wie es aus der DE-A-3709227 bekannt ist, wogegen Anspruch 1 abgegrenzt ist. Unter Wechselstrom wird sowohl ein- als auch mehrphasiger Wechselstrom verstanden, insbesondere auch dreiphasiger Wechselstrom (Drehstrom). Bisher hat man üblicherweise solche Verteilersysteme in Schalträsten angeordnet, wobei für jeden Verbraucher beispielsweise einem Drehstrommotor, eine gesonderte Sicherung, eine Lastschalteinheit (Schütz) und ab einer bestimmten Stromstärke ansprechende Motorschutzschalter vorgesehen waren. Alle diese Komponenten müssen für jeden Verbraucher aufgebaut und dann einzeln im Schaltkasten verdrahtet werden. Bei Anlagen mit mehreren Verbrauchern ergibt dies zwangsweise einen ständig sich wiederholenden Arbeitsvorgang. Um dies zu vermeiden, wurde bereits vorgeschlagen, für jeden Verbraucher ein eigenes Baugruppenmodul vorzusehen, auf dem Sicherung(en), Lastschalteinheiten etc. vormontiert angeordnet sind und das an einem von mehreren Plätzen eines Baugruppenträgers anschließbar ist.

Aufgabe der Erfindung ist es, ein modularaufgebautes Verteilersystem zu schaffen, mit dem eine einfache und zuverlässige Überwachung bzw. Steuerung der Baugruppenmodule möglich ist.

Erfindungsgemäß wird dies durch die kennzeichnenden Merkmale des Anspruchs 1 erreicht.

Ein solches Meß- und/oder Steuermodul kann günstigerweise dem in einem Baugruppenträger eingeschobenen Baugruppenmodul eingeschoben werden und damit über vormontierte Steckverbinder und Leitungen im Baugruppenträger elektrisch mit den einzelnen Baugruppenmodulen in Kontakt treten. Dieses Einschieben des Meß- und/oder Steuermoduls kann auch nur von Zeit zu Zeit geschehen, immer dann, wenn eine Messung oder eine Steuerung der Baugruppenmodule nötig ist. Dies kann beispielsweise bei mehreren gleichartigen Verteilersystemen günstig sein, weil man dann für alle Verteilersysteme nur ein einziges Meß- und/oder Steuermodul benötigt. Andererseits wird man in der Praxis auch häufig an einer ständigen Überwachung bzw. Steuerung der Baugruppenmodule des Verteilersystems interessiert sein. In diesem Fall kann dann das Meß- und/oder Steuermodul im Verteilersystem bleiben. Der wesentliche Vorteil besteht dann in einer Zentralisierung der Meß- und/oder Steuerfunktionen im Meß- und/oder Steuermodul, sodaß die einzelnen, mehreren gleichartig aufgebauten Baugruppenmodule einfacher aufgebaut sein können. Sie benötigen grundsätzlich keine eigenen Anzeigen und keine eigenen Steuervorrichtungen, wenngleich natürlich die Anbringung zusätzlicher Anzeigen bzw. Steuervorrichtungen an den einzelnen Baugruppenmodulen selbst nicht ausgeschlossen ist.

Besonders günstig ist eine Ausführungsform, bei der das Meß- und/oder Steuermodul eine Umschalteinrichtung aufweist, über die wahlweise ein bestimmter der zwei oder mehreren Baugruppenmodule selektiv ansprechbar bzw. abfragbar ist. Das Meß- und/oder Steuermodul weist dann typischerweise nicht für jedes Baugruppenmodul eine eigene Anzeige oder eine eigene Steuervorrichtung auf.

Vielmehr brauchen diese nur einfach vorhanden sein und können über die Umschalteinrichtung wahlweise für eines der Baugruppenmodule aktiviert werden. Beispielsweise ist es möglich, als Meßsignal von jedem Baugruppenmodul ein vom Stromfluß zum jeweiligen Verbraucher proportionales Signal bereitzustellen, wobei eine Anzeigevorrichtung des Meß- und/oder Steuermoduls wahlweise dieses Meßsignal anzeigt. Über die Umschalteinrichtung kann dann einfach ausgewählt werden, von welchem Baugruppenmodul bzw. Verbraucher gerade der Stromfluß angezeigt wird. Welcher der gerade ausgewählte Verbraucher ist, kann ebenfalls über eine Anzeige angezeigt werden.

Weitere Vorteile und Einzelheiten der Erfindung werden anhand der nachstehenden Figurenbeschreibung näher erläutert:
- Fig. 1: zeigt eine schematische perspektivische Darstellung eines Baugruppenträgers und eines einzelnen Baugruppenmoduls vor dem Einschieben in den Baugruppenträger;
- Fig. 2: zeigt ein Baugruppenmodul in einer Seitenansicht;
- Fig. 3: zeigt den Baugruppenträger mit montierten Baugruppenmodulen in einer Vorderansicht;
- Fig. 4: zeigt in stark schematisierter Darstellung zwei Baugruppenmodule, die mit einem gesonderten Meß- und/oder Steuermodul in Verbindung stehen;
- Fig. 5: zeigt ein Ausführungsbeispiel eines Meß- und/oder Steuermoduls, das in seinen baulichen Abmessungen mit dem in Fig. 3 dargestellten Baugruppenmodul übereinstimmt;
- Fig. 6: zeigt eine Steckerleiste mit Verbindungssteckerteilen, die über einen speziellen Busprint (Verbindungsleitungen) miteinander elektrisch verbunden sind.

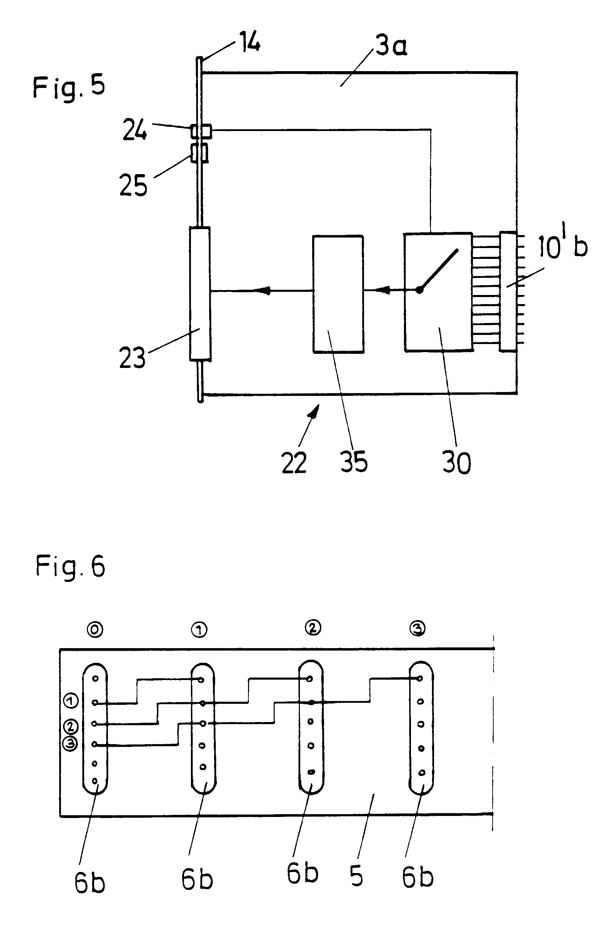

Der Baugruppenträger 1 besteht im wesentlichen aus einem Gehäuse la und Führungen 2, in die die Baugruppenmpodule 3 eingeschoben werden können. An der Hinterwand weist der Baugruppenträger 1 eine Starkstromsteckerleiste 4 (beispielsweise 220V oder 380V Netzspannung) und eine Schwachstromsteckerleiste 5 auf, auf der pro Baugruppenmodul jeweils ein Steckverbinderteil 6a, 6b angeordnet ist. Diese Steckverbinderteile (beispielsweise eine Reihe von Buchsen oder Messerleisten) kann jeweils über Leitungen 7 mit einem der Verbraucher M1, M2, etc. verbunden werden. Die Steckverbinderteile 6b der Schwachstromsteckerleiste 5 sind über mehrere busartig ausgeführte Leitungen untereinander verbunden (siehe beispielsweise Fig. 6) und können über Leitungen 8 auch mit einem externen Steuergerät 9 in Verbindung stehen.

Jedes Baugruppenmodul 3 weist eine Platine 3a auf, auf der zwei Steckverbinderteile 10a, 10b angeordnet sind, die beim Einschieben des Baugruppenmoduls 3 in den Baugruppenträger 1 automatisch in die dort befestigten Steckverbinderteile 6a, 6b eingreifen und mit den dort vorgesehenen Kontakten eine elektrische Verbindung herstellen. Auf der Platine 3a, die vorzugsweise in doppeltem Europakartenformat dimensioniert ist, befindet sich ein schematisch eingezeichneter Lastteil 11, der vorzugsweise neben Schalteinheiten auch Sicherungen 12 umfaßt. Weiters befindet sich auf der Platine 3a ein Schwachstromteil 13 mit mehreren elektronischen Bauelementen. Dieser Schwachstromteil 13 ist galvanisch vom Lastteil 11 getrennt, kann diesen jedoch steuern bzw. daran Messungen vornehmen und über den Steckerteil 10b Meßsignale abgeben bzw. Steuersignale empfangen.

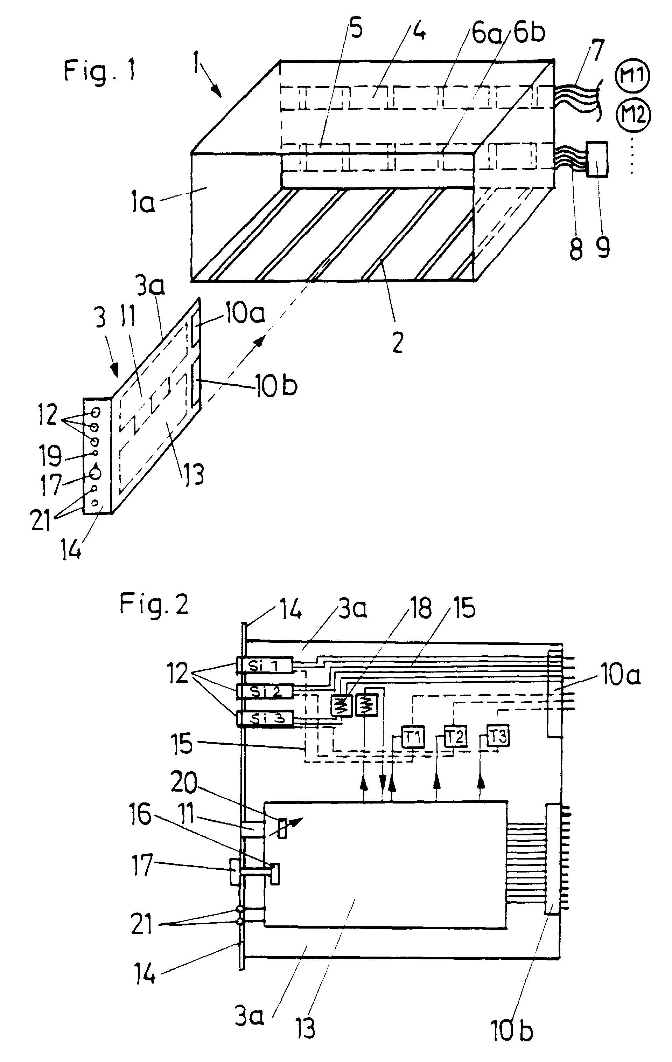

Die Fig. 2 zeigt ein Ausführungsbeispiel eines Baugruppenmoduls für einen Verbraucher in einer Seitenansicht. An der Platine 3a ist vorne eine Frontplatte 14 befestigt, durch die die wichtigsten Elemente zugänglich bzw. ersichtlich sind. Vom Steckerteil 10a führen auf der Platine aufgedruckte Starkstromleiterbahnen 15 zu den Sicherungen 12 und von dort (strichliert angedeutet) auf der Hinterseite der Platine über die Thyristorschalter (Triac) T1,T2 und T3 zum Steckerteil 10a zurück. Die Steckerkontakte des Lasteinganges des Steckerteiles 10a werden vom Netz her mit Strom versorgt. Der Lastausgang führt zum Verbraucher. Die Thyristorschalter T1,T2,T3 werden vom elektronischen Schwachstromteil 13, der nur stark schematisiert dargestellt ist, gesteuert. Dies ist beispielsweise über den Handschalter 16 mit Betätigungsgriff 17 möglich. Aber auch über den Schwachstrom-Steckerteil 10b können Steuersignale zur Steuerung insbesondere der Thyristorschalter T1,T2 und T3 zugeführt werden.

Neben den schnell ansprechenden Kurzschlußsicherungen 12 ist auch noch eine Stromübervachungseinrichtung vorgesehen, die den Verbraucher ab einem bestimmten, einstellbaren Laststrom abschaltet. Diese Stromüberwachungseinrichtung umfaßt einen Transformator, über den primärseitig eine der drei Phasen des Laststromes geführt ist. Sekundärseitig und damit galvanisch getrennt steht dann ein laststromproportionales Signal zur Verfügung, das in der Elektronik 13 verarbeitet werden kann. Am einfachsten ist ein Vergleich mit einem Sollwert. Dieser Sollwert kann durch eine Öffnung 19 in der Frontplatte 14 hindurch, beispielsweise mittels eines Schraubenziehers am Trimmpotentiometer 20 eingestellt werden oder von außen über den Steckerteil 10b vorgegeben werden. Ubersteigt der Istwert den Sollwert, so schaltet der elektronische Schwachstromteil 13 die Thyristorschalter T1,T2,T3 ab. Ein solches Abschalten erfolgt auch, wenn eine der Sicherungen 12 oder eine Netzphase ausfällt, aber auch bei einem Unterbrechen der Leitung nach den Thyristorschaltern. Damit braucht nur eine der drei Phasen, die normalerweise die gleiche Stromstärke führen, überwacht zu werden. Anzeigeelemente 21 an der Frontplatte 14 geben beispielsweise den jeweiligen Schaltzustand der Thyristoren wieder.

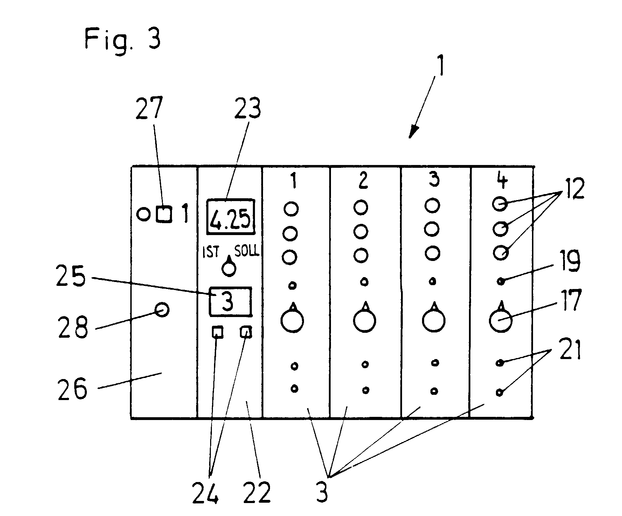

Die Fig. 3 zeigt einen Baugruppenträger 1 mit vier eingeschobenen Baugruppenmodulen für vier nicht dargestellte Wechselstrom- Verbraucher (beispielsweise Drehstrommotoren), welche untereinander identisch aufgebaut und auch gegeneinander austauschbar sind. Abgesehen von vier Baugruppenmodulen 3 ist erfindungsgemäß noch ein Meß- und/oder. Steuermodul 22 vorgesehen. Dieser steht über ein busartiges System (vgl. beispielsweise Fig. 6) in der Steckerleiste 5 mit den Schwachstrom-Steckverbinderteilen 6b der einzelnen Baugruppenmodule in Verbindung. Mit einem solchen Meß- und/oder Steuermodul ist es beispielsweise möglich, auf einer Anzeigevorrichtung 23 den Istwert oder Sollwert eines über die Wahlschalter 24 ausgewählten Baugruppenmoduls bzw. des daran angeschlossenen Verbrauchers anzuzeigen. Das jeweils gewählte Baugruppenmodul bzw. Verbraucher erscheint in der Anzeige 25. Damit ist es mit einem einzigen Meß- und/oder Steuermodul 22 möglich, mehrere Baugruppenmodule 3 zu überwachen bzw. auch extern zu steuern.

Schließlich befindet sich im Baugruppenträger (Rack) noch ein Stromversorgungsmodul 26 für die Elektronikkomponenten auf den Baugruppenmodulen. Dieses Modul 26 weist einen Hauptschalter 27 und eine Sammelstörungsanzeige 28 auf, wobei eine solche Störung auch extern weitergemeldet und/oder von der Ferne quittiert werden kann.

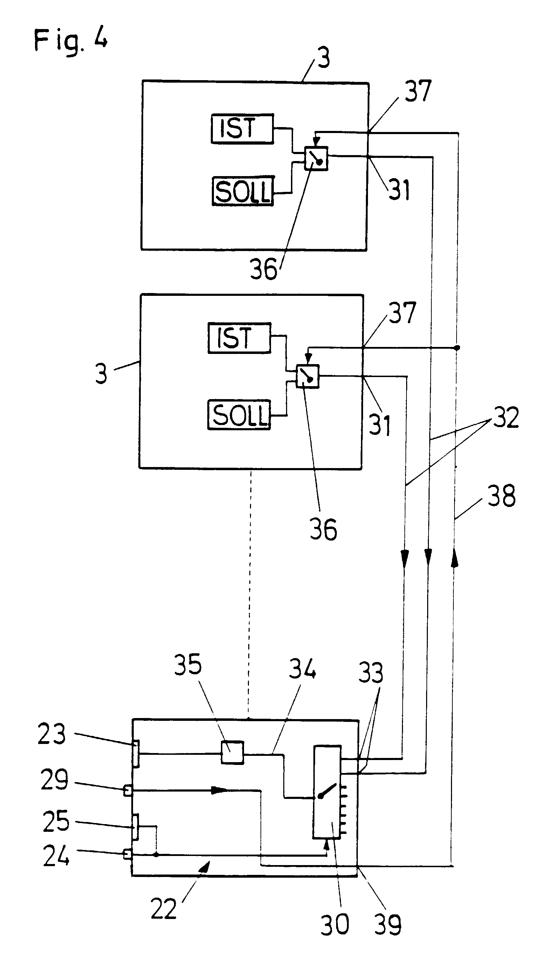

Die Fig. 4 zeigt beispielhaft zwei Baugruppenmodule und einen damit elektrisch verbundenen Meß- und/oder Steuermodul 22 in stark schematisierter Darstellung. Bei dem in Fig. 4 dargestellten Ausführungsbeispiel ist es möglich, am Meß- und/oder Steuermodul 22 über die Anzeigevorrichtung 23 Meßsignale aus einem ausgewählten Baugruppenmodul 3 anzuzeigen. Zur Auswahl des Baugruppenmoduls ist eine Umschalteinrichtung 30 vorgesehen, über die wahlweise ein bestimmter der zwei oder mehreren Baugruppenmodule 3 selektiv ansprechbar ist. Das ausgewählte Baugruppenmodul 3 läßt sich über Wahltasten 24 einstellen, wobei die Nummer des eingestellten Baugruppenmoduls 3 auf einer Anzeige 5 angezeigt wird. Der Umschalter 30 kann natürlich auch als elektronischer Schalter realisiert sein.

Vorteilhaft weist jedes Baugruppenmodul mindestens einen Meßausgang 31 auf, der über eine Meßleitung 32 mit dem zugehörigen Meßeingang 33 des Meß- und/oder Steuermoduls 22 in Verbindung steht. Über den Umschalter 30 läßt sich nun wahlweise eine der Leitungen 32 auf die Leitung 34 schalten und dann über einen Meßwandler 35 der Anzeigevorrichtung 23 zuführen.

Zur Auswahl, welches Meßsignal über die Leitungen 32 von den Baugruppenmodulen an das Meß- und/oder Steuermodul 22 geliefert wird, weisen die Baugruppenmodule eine Umschalteinheit 36 auf, über die wahlweise verschiedene Meßsignale auf einen Meßausgang 31 anlegbar sind. Diese Umschalteinheiten 36 sind vorteilhaft über einen Steuereingang 37 am Baugruppenmodul 3 vom zentralen Meß- und/oder Steuermodul 22 aus steuerbar und zwar über den Wahlschalter 29, den Steuerausgang 39 und die Steuerleitungen 38. Die Stellung des Wahlschalters 29 bestimmt also die Stellung der Umschalteinheit 36 und damit, welches Meßsignal auf den Leitungen 32 anliegt und letztlich über die Anzeigevorrichtung 23 angezeigt wird. Beim vorliegenden Ausführungsbeispiel kann über die Umschalteinheit 36 beispielsweise zwischen der Anzeige eines zum Stromistwert proportionalen Meßsignales und des eingestellten Stromsollwertes umgeschaltet werden. Die Baugruppenmodule 3 weisen dazu eine nicht näher dargestellte Strommeßeinrichtung auf, die ein zur Stromstärke des zum Verbraucher fließenden Stromes proportionales Meßsignal abgibt. Weiters können die Baugruppenmodule eine an sich bekannte Strombegrenzerschaltung aufweisen, die oberhalb eines einstellbaren Stromsollwertes den Strom zum Verbraucher abschaltet und die ein zum Stromsollwert proportionales Meßsignal abgibt. Die genannten Meßsignale können dann beispielsweise über eine Umschalteinheit 36 dem Meß- und/oder Steuermodul zugeführt werden.

In der Praxis sind die Steuereingänge 37 und Meßausgänge 31 der Baugruppenmodule 3 günstigerweise auf einem mehrpoligen Steckverbinderteil realisiert, wie er beispielsweise in Fig. 2 mit 10b bezeichnet ist. Die Meßeingänge 33 und der Steuerausgang 39 des Meßund/oder Steuermoduls 22 können ebenfalls auf einen mehrpoligen Steckverbinderteil ausgebildet sein, wie dies beispielsweise in Fig. 5 mit 10'b dargestellt ist. Die elektrischen Leitungen 32 und 38 können in der Steckerleiste des Baugruppenträgers 1 realisiert sein, beispielsweise als Busprint in der Art der Fig. 6.

Die Fig. 5 zeigt, daß das Meß- und/oder Steuermodul 22 im Hinblick auf die äußeren Abmessungen im wesentlichen gleich aufgebaut ist, wie das Baugruppenmodul 3 der Fig. 2. Es ist dort ebenfalls eine Leiterplatine 3a vorgesehen und eine Frontblende 14. Der Steckerteil 10'b ist mit der Umschalteinrichtung 30 verbunden, die über einen Meßwandler 35 zu einer Anzeige 23 führt. Über einen Wahlschalter 24 kann das jeweils anzusprechende Baugruppenmodul 3 ausgewählt werden, wobei die Auswahl über die Anzeige 25 angezeigt wird. Das so ausgebildete Meß- und/oder Steuermodul paßt somit in denselben Baugruppenträger 1, wie die einzelnen Baugruppenmodule 3.

Die in Fig.6 dargestellte Steckerleiste ist als Busprint aufgebaut, wobei die zwischen den einzelnen Steckerverbindertielen 6b eingezeichneten Leitungen als aufgedruckte Leitungen realisiert sein können. Durch die in Fig. 6 dargestellte Leitungsführung ist es möglich, von jedem Steckplatz (eingekreiste Ziffern 1 bis 3) zum Steckplatz mit der eingekreisten Ziffer 0 Meßsignale zu übertragen, die vom jeweils obersten Anschlußpol der mehrpoligen Verbindungssteckerteile 6b kommen. Am Steckverbinderteil mit der eingekreisten Ziffer 0 kann beispielsweise das Meß- und/oder Steuermodul angeschlossen werden, wobei an den Anschlußpolen definitiv festliegt, von welchem obersten Anschlußpohl das jeweilige Meßsignal stammt. Bei dem in Fig. 6 gezeigten Ausführungsbeispiel dürfen natürlich die zweiten und dritten Anschlußpole jedes Steckverbinderteiles mit den eingekreisten Ziffern 1 bis 3 nicht mit Meßsignalen beaufschlagt werden, da diese Anschlußpole lediglich zum Durchschleusen der Meßsignale benachbarter oder entfernter Steckverbinderteile 6b dienen.

Mit einem solchen System, das sich auch leicht erweitern läßt, können gleichzeitig mehrere Starkstrom-Verbraucher geschaltet und überwacht werden. Insgesamt ergibt sich neben der Zeit- und Kostenersparnis auch eine kleinere Bauweise gegenüber herkömmlichen Schaltkästen.

## Patentansprüche

1. Verteilersystem für zwei oder mehrere Verbraucher, insbesondere WechselstromVerbraucher, das einen Baugruppenträger (1) mit einer Starkstromsteckerleiste (4) und einer Schwachstromsteckerleiste (5) und für jeden Verbraucher ein eigenes, den Strom zum Verbraucher schaltendes Baugruppenmodul (3) aufweist, das über Steckverbinderteile (6a, 6b) mit der Starkstromsteckerleiste und der Schwachstromsteckerleiste verbindbar ist, dadurch gekennzeichnet, daß das Verteilersystem neben den Baugruppenmodulen (3) für die Verbraucher (M1, M2) ein gesondertes Meßmodul (22) umfaßt, das eine Anzeigevorrichtung (23) zum Anzeigen von Meßsignalen, wie den Stromistwert oder den Stromsollwert, aus den einzelnen Baugruppenmodulen (3) aufweist, wobei das Meßmodul (22) eine Umschalteinrichtung (30) aufweist, über die wahlweise ein bestimmtes der zwei oder mehreren Baugruppenmodule (3) selektiv abfragbar ist, und wobei gleichartige Meßsignale der verschiedenen Baugruppenmodule (3) wahlweise hintereinander über dieselbe Anzeigevorrichtung (23) angezeigt werden können.

2. Verteilersystem nach Anspruch 1, dadurch gekennzeichnet, daß das Meßmodul (22) eine Anzeige (25) aufweist, die das über die Umschalteinrichtung (30) gerade angesprochene Baugruppenmodul (3) angibt.

3. Verteilersystem nach einem der Ansprüche loder 2, dadurch gekennzeichnet, daß die Baugruppenmodule (3) jeweils mindestens einen Meßausgang (31) aufweisen, der über eine Meßleitung (32) mit einem zugehörigen Meßeingang (33) des Meßmoduls (22) in Verbindung steht.

4. Verteilersystem nach einem der Ansprüche 1 bis 3, dadurch gekennzeichnet, daß die Baugruppenmodule jeweils eine Umschalteinheit (36) aufweisen, über die wahlweise verschiedene Meßsignale auf einen Meßausgang (31) anlegbar sind.

5. Verteilersystem nach Anspruch 4, dadurch gekennzeichnet, daß die Umschalteinheit (36) über einen Steuereingang (37) am Baugruppenmodul (3) vom zentralen Meß- und/oder Steuermodul (22) aus steuerbar ist.

6. Verteilersystem nach einem der Ansprüche 1 bis 5, dadurch gekennzeichnet, daß die Baugruppenmodule (3) jeweils eine Strommeßeinrichtung aufweisen, die ein zur Stromstärke des zum Verbraucher fließenden Stromes proportionales Meßsignal abgibt.

7. Verteilersystem nach einem der Ansprüche 1 bis 6, dadurch gekennzeichnet, daß die Baugruppenmodule jeweils eine Strombegrenzerschaltung aufweisen, die oberhalb eines einstellbaren Stromsollwertes den Strom zum Verbraucher abschaltet und die ein zum Stromsollwert proportionales Meßsignal abgibt.

8. Verteilersystem nach einem der Ansprüche 1 bis 7, dadurch gekennzeichnet, daß es einen Baugruppenträger (1) mit mehreren Anschlußplätzen für die Baugruppenmodule (3) und das Meßmodul (22) umfaßt.

9. Verteilersystem nach Anspruch 8, dadurch gekennzeichnet, daß die Anschlußplätze im Baugruppenträger über elektrische Leitungen vorzugsweise auf einem Busprint miteinander in Verbindung stehen.

10. Verteilersystem nach Anspruch 8 oder Anspruch 9, dadurch gekennzeichnet, daß die Anschlußplätze im Baugruppenträger mehrpolige Steckverbinderteile (6a, 6b) umfassen und die Baugruppenmodule (3), sowie das Meßmodul (22) ihrerseits Steckverbinderteile (10a, 10b) aufweisen, die mit den Steckverbinderteilen (6a, 6b) im Baugruppenträger (1) zusammenpassen.

11. Verteilersystem nach Anspruch 9 und Anspruch 10, dadurch gekennzeichnet, daß ein erster Anschlußpol eines Steckverbinderteiles des Baugruppenträgers jeweils mit jenem Anschlußpol des benachbarten gleichartigen Steckverbinderteiles verbunden ist, der zu jenem Anschlußpol dieses Steckverbinderteiles benachbart ist, der an derselben Stelle liegt wie der erste Anschlußpol im einen Steckverbinderteil.

12. Verteilersystem nach einem der Ansprüche 1 bis 11, dadurch gekennzeichnet, daß die Baugruppenmodule (3) und das gesonderte Meßmodul (22) im Hinblick auf die äußeren Abmessungen und zumindest einen der elektrischen Anschlüsse baugleich aufgebaut sind.

13. Verteilersystem nach einem der Ansprüche 1 bis 12, dadurch gekennzeichnet, daß jedes Baugruppenmodul (3) eine, eingebaut vorzugsweise vertikal stehende Leiterplatine (3a) aufweist, die mit elektronischen und elektrischen Bauteilen bestückt ist und an deren Vorderseite eine Frontplatte (14) mit Bedienungs- (17) und/oder Anzeigeelementen (21) angeordnet ist.

14. Verteilersystem nach Anspruch 13, dadurch gekennzeichnet, daß die Leiterplatine (3a) einfaches oder doppeltes Europakartenformat hat.

15. Verteilersystem nach einem der Ansprüche 1 bis 14, dadurch gekennzeichnet, daß die Baugruppenmodule (3) neben einem den Strom zum Verbraucher schaltenden Lastteil jeweils einen davon galvanisch getrennten elektronischen Schwachstromteil aufweisen, der Regel-, Steuer- und/oder Meßfunktionen am Lastteil (11) ausführt.

16. Verteilersystem nach Anspruch 15, dadurch gekennzeichnet, daß der Lastteil (11) und der Schwachstromteil (13) auf ein und derselben Platine angeordnet sind, wobei sowohl die Leitungen des Schwachstromteiles als auch die des Lastteiles als Leiterbahnen auf der Platine (3a) ausgebildet sind.

17. Verteilersystem nach Anspruch 15 oder 16, dadurch gekennzeichnet, daß der Schwachstromteil über einen vom Laststeckverbinder (10a) gesonderten Steckverbinder (10b) mit einer Steckerleiste im Baugruppenträger (1) verbindbar ist.

## Claims

1. A distribution system for two or more consumers, in particular alternating current consumers, which has an assembly carrier (1) with a heavy-current multipoint connector (4) and a weak-current multipoint connector (5) and for each consumer a specific assembly module (3) which switches the current to the consumer and which can be connected by way of plug connector portions (6a, 6b) to the heavy-current multipoint connector and the weak-current multipoint connector, characterised in that besides the assembly modules (3) for the consumers (M1, M2) the distribution system includes a separate measuring module (22) which has a display device (23) for displaying measurement signals such as the current actual value or the current reference value from the individual assembly modules (3), wherein the measuring module (22) has a change-over switching device (30) by way of which optionally a given one of the two or more assembly modules (3) can be selectively interrogated and wherein similar measuring signals of the various assembly modules (3) can be displayed selectively one after the other by way of the same display device (23).

2. A distribution system according to claim 1 characterised in that the measuring module (22) has a display (25) which specifies the assembly module (3) which is just being addressed by way of the change-over switching device (30).

3. A distribution system according to one of claims 1 and 2 characterised in that the respective assembly modules (3) each have at least one measuring output (31) which is connected by way of a measuring line (32) to an associated measuring input (33) of the measuring module (22).

4. A distribution system according to one of claims 1 to 3 characterised in that the respective assembly modules each have a change-over switching unit (36) by way of which various measuring signals can be selectively applied to a measuring output (31).

5. A distribution sytem according to claim 4 characterised in that the change-over switching unit (36) is controllable from the central measuring and/or control module (22) by way of a control input (37) at the assembly module (3).

6. A distribution system according to one of claims 1 to 5 characterised in that the respective assembly modules (3) each have a current measuring device which outputs a measurement signal proportional to the current strength of the current flowing to the consumer.

7. A distribution system according to one of claims 1 to 6 characterised in that the respective assembly modules each have a current limiting circuit which above a settable current reference value switches off the current to the consumer and which outputs a measurement signal proportional to the current reference value.

8. A distribution system according to one of claims 1 to 7 characterised in that it includes an assembly carrier (1) having a plurality of connecting positions for the assembly modules (3) and the measuring module (22).

9. A distribution system according to claim 8 characterised in that the connecting positions in the assembly carrier are connected together by way of electrical lines, preferably on a bus print.

10. A distribution system according to claim 8 or claim 9 characterised in that the connecting positions in the assembly carrier include multi-pole plug connector portions (6a, 6b) and the assembly modules (3) and the measuring module (22) in turn have plug connector portions (10a, 10b) which fit together with the plug connector portions (6a, 6b) in the assembly carrier (1).

11. A distribution system according to claim 9 and claim 10 characterised in that a first connecting terminal of a plug connector portion of the assembly carrier is respectively connected to that connecting terminal of the adjacent similar plug connector portion which is adjacent to that connecting terminal of said plug connector portion which is at the same location as the first connecting terminal in a plug connector portion.

12. A distribution system according to one of claims 1 to 11 characterised in that the assembly modules (3) and the separate measuring module (22) are of the same structural design in regard to the external dimensions and at least one of the electrical connections.

13. A distribution system according to one of claims 1 to 12 characterised in that each assembly module (3) has a printed circuit board (3a) which is preferably disposed vertically when installed and which is equipped with electronic and electrical components and at the front side of which is arranged a front plate (14) with operating (17) and/or display elements (21).

14. A distribution system according to claim 13 characterised in that the printed circuit board (3a) is of a single or double Europa card format.

15. A distribution system according to one of claims 1 to 14 characterised in that, besides a load portion for switching the current to the consumer, the assembly modules (3) each have an electronic weak-current portion which is galvanically separated therefrom and which performs regulating, control and/or measuring functions at the load portion (11).

16. A distribution system according to claim 15 characterised in that the load portion (11) and the weak-current portion (13) are arranged on one and the same board, wherein both the lines of the weak-current portion and also those of the load portion are in the form of conductor tracks on the board (3a).

17. A distribution system according to claim 15 or claim 16 characterised in that the weak-current portion can be connected to a multipoint connector in the assembly carrier (1) by way of a plug connector (10b) which is separate from the load plug connector (10a).

## Revendications

1. Système de distribution pour deux ou plusieurs récepteurs, en particulier pour des récepteurs à courant alternatif, qui comprend un coffret de connexion (1), muni d'une barre de connexion pour courant haute tension (4) et d'une barre de connexion pour courant basse tension (5), et un module pour composants (3) séparé pour chaque récepteur, destiné à commuter le courant vers le récepteur, lequel module peut être relié à la barre de connexion pour courant haute tension et à la barre de connexion pour courant basse tension par l'intermédiaire de connecteurs à fiches (6a, 6b), caractérisé en ce que le système de distribution comprend, outre les modules pour composants (3) pour les récepteurs (Ml, M2), un module de mesure (22) séparé, qui comporte une unité d'affichage (23) pour afficher les signaux de mesure, telle que la valeur effective du courant ou la valeur de consigne du courant, transmis par chaque module pour composants (3), le module de mesure (22) étant muni d'un dispositif de commutation (30), qui permet à volonté de lire par appel sélectif un module pour composants (3) déterminé parmi les deux ou parmi plusieurs modules pour composants, et des signaux de mesure de même nature transmis par les différents modules pour composants (3) pouvant être affichés à volonté l'un après l'autre sur la même unité d'affichage (23).

2. Système de distribution selon la revendication 1, caractérisé en ce que le module de mesure (22) est muni d'un afficheur (25), qui affiche le module pour composants (3) déclenché à l'instant présent par l'intermédiaire du dispositif de commutation (30).

3. Système de distribution selon la revendication 1 ou 2, caractérisé en ce que chaque module pour composants (3) est muni au moins d'une sortie pour signaux de mesure (31), qui communique par l'intermédiaire d'une ligne de transmission des signaux de mesure (32) avec l'entrée pour signaux de mesure (33) correspondante au module de mesure (22).

4. Système de distribution selon l'une quelconque des revendications 1 à 3, caractérisé en ce que chaque module pour composants est muni d'une unité de commutation (36), qui permet de transmettre à volonté différents signaux de mesure vers une sortie pour signaux de mesure (31).

5. Système de distribution selon la revendication 4, caractérisé en ce que le dispositif de commutation (36) peut être commandé par le module de mesure central et/ou le module de commande (22), par l'intermédiaire d'une entrée pour signaux de commande (37) sur le module pour composants (3).

6. Système de distribution selon l'une quelconque des revendications 1 à 5, caractérisé en ce que chaque module pour composants (3) est muni d'une unité de mesure du courant, qui émet un signal de mesure proportionnel à l'intensité du courant circulant vers le récepteur.

7. Système de distribution selon l'une quelconque des revendications 1 à 6, caractérisé en ce que chaque module pour composants est muni d'un limiteur de courant qui déconnecte le courant vers le récepteur lorsque le courant est supérieur à une valeur de consigne donnée et qui émet un signal de mesure proportionnel à la valeur de consigne du courant.

8. Système de distribution selon l'une quelconque des revendications 1 à 7, caractérisé en ce qu'il comprend un coffret de connexion (1) muni de plusieurs bornes pour les modules pour composants (3) et le module de mesure (22).

9. Système de distribution selon la revendication 8, caractérisé en ce que les bornes dans le coffret de connexion communiquent les unes avec les autres par l'intermédiaire de lignes électriques, de préférence sur une plaquette de circuits imprimés pour bus.

10. Système de distribution selon la revendication 8 ou la revendication 9, caractérisé en ce que les bornes dans le coffret de connexion comprennent des connecteurs multibroches (6a, 6b), et les modules pour composants (3), ainsi que le module de mesure (22) sont munis pour leur part de connecteurs à fiches (10a, 10b), qui coïncident avec les connecteurs à fiches (6a, 6b) dans le coffret de connexion (1).

11. Système de distribution selon la revendication 9 ou la revendication 10, caractérisé en ce qu'un premier pôle de connexion d'un connecteur à fiches du coffret de connexion est relié respectivement au pôle de connexion du connecteur à fiches de même nature voisin, lequel pôle de connexion est contigu au pôle de connexion de ce connecteur à fiches, qui est situé au même emplacement que le premier pôle de connexion dans un connecteur à fiches.

12. système de distribution selon l'une quelconque des revendications 1 à 11, caractérisé en ce que les modules pour composants (3) et le module de mesure (22) séparé sont conçus de manière similaire sur le plan des dimensions extérieures et au moins sur le plan de l'une des connexions électriques.

13. Système de distribution selon l'une quelconque des revendications 1 à 12, caractérisé en ce que chaque module pour composants (3) est formé par une plaquette de circuits imprimés (3a), montée de préférence en position verticale, qui est équipée de composants électroniques et électriques et dont la face avant est constituée par une plaque frontale (14) avec des éléments de commande (17) et/ou des éléments d'affichage (21).

14. Système de distribution selon la revendication 13, caractérisé en ce que le plaquette de circuits imprimés (3a) est réalisée selon le format simple ou double des plaquettes aux normes européennes.

15. Système de distribution selon l'une quelconque des revendications 1 à 14, caractérisé en ce que chaque module pour composants (3) est muni, outre un organe de charge destiné à commuter le courant vers le récepteur, d'un composant électronique pour courant basse tension, séparé par voie galvanique dudit organe de charge et qui transmet vers l'organe de charge (11) les fonctions de réglage, de commande et/ou de mesure.

16. Système de distribution selon la revendication 15, caractérisé en ce que l'organe de charge (11) et le composant pour courant basse tension (13) sont montés sur la même plaquette, les conducteurs pour le composant pour courant basse tension ainsi que ceux pour l'organe de charge étant conçus sous forme de pistes conductrices tracées sur la plaquette (3a).

17. Système de distribution selon la revendication 15 ou 16, caractérisé en ce que le composant pour courant basse tension peut être raccordé à une barre de connexion dans le coffret de connexion (1) par l'intermédiaire d'un connecteur à fiches (10b), séparé du connecteur à fiches de charge (10a).
